# EUROPÄISCHE PATENTSCHRIFT

(11) **EP 1 049 362 B1**
(45) Veröffentlichungstag und Bekanntmachung des Hinweises auf die Patenterteilung: **31.05.2006**
(21) Anmeldenummer: 00108615.6
(22) Anmeldetag: 20.04.2000
(51) Int. Cl.: H05K 1/02

(54) **Leiterplatte mit wärmeleitendem Bereich**
Circuit substrate with heat conducting portion
Plaquette à circuit comportante une région conductrice pour la chaleur

(30) Priorität: 30.04.1999 DE 19919781
(43) Veröffentlichungstag der Anmeldung: 02.11.2000
(73) Patentinhaber: Würth Elektronik Rot am See GmbH & Co. KG, 74585 Rot am See (DE)
(72) Erfinder: Kostelnik, Jan, Dr., 74592 Kirchberg/J. (DE)
(74) Vertreter: Patentanwälte Ruff, Wilhelm, Beier, Dauster & Partner

(56) Entgegenhaltungen:
- EP-A- 0 871 352
- WO-A-99/02023
- DE-A- 19 506 664
- DE-A- 19 528 632
- DE-A- 19 654 353
- US-A- 4 628 407
- US-A- 5 513 070
- US-A- 5 590 462

## Beschreibung

Bei Leiterplatten wird die Packungsdichte immer enger. Dadurch besteht ein Bedarf, die im Betrieb der Bauteile auftretende Wärme abführen zu können.

Bei Leiterplatten sind MicroVias bekannt, also Bohrungen oder Sacklöcher, die mit Hilfe verschiedener Verfahren hergestellt werden können. Diese MicroVias lassen sich mit wesentlich kleineren Durchmessern herstellen.

Es ist bereits eine Leiterplatte mit durchgehenden Microvias bekannt (EP 871352). Auf der einen Seite der Leiterplatte ist ein elektronisches Bauteil mit einem Kühlkörper angeordnet, während auf der gegenüberliegenden Seite der Leiterplatte ebenfalls ein Kühlkörper angeklebt ist.

Weiterhin bekannt ist eine Leiterplatte mit durchgehenden Bohrungen, die mit Wärme leitendem Material gefüllt sind (US-A-5590462).

Ebenfalls bekannt ist es, Leiterplatten an Vorsprüngen von Trägern anzubringen, wobei die Leiterplatte mit Ausnahme des Vorsprungs einen Abstand von dem Träger aufweist (US-A-4628407).

Weiterhin ist bei einem Steuergerät eine Leiterplatte bekannt, bei der zwischen einem Ankopplungsbereich der Leiterplatte und einem Gehäuseteil ein Füllstoff aus einem Klebstofffilm mit wärmeleitfähigen Eigenschaften angeordnet ist (DE 19528632). Es handelt sich dabei um einen aushärtenden Kleber.

Der Erfindung liegt die Aufgabe zugrunde, eine einfache und auf engem Raum unterzubringende Möglichkeit zur Wärmeabfuhr bei Leiterplatten zu schaffen.

Zur Lösung dieser Aufgabe schlägt die Erfindung eine Leiterplatte mit den Merkmalen des Anspruchs 1 vor. Die Erfindung schlägt ebenfalls ein Verfahren mit den im Anspruch 15 genannten Merkmalen vor. Weiterbildungen der Erfindung sind Gegenstand der abhängigen Ansprüche, deren Wortlaut ebenso wie der Wortlaut der Zusammenfassung durch Bezugnahme zum Inhalt der Beschreibung gemacht wird.

Der Ankopplungsbereich soll dazu dienen, in der Leiterplatte entstehende Wärme an einer bestimmten Stelle abzuleiten. DerAnkopplungsbereich wird dadurch definiert, dass eine Mehrzahl von Microvias zur Bildung eines Arrays angebracht wird. Dies kann mit den bei Microvias bekannten Verfahren geschehen, also durch Ätzen, mit Hilfe von Lasern oder dergleichen.

In Weiterbildung der Erfindung kann vorgesehen sein, dass der Ankopplungsbereich mit einer Klebefolie direkt kontaktiert ist, die thermisch leitend ist. Mit Hilfe der Klebefolie kann an dem Ankopplungsbereich ein Gegenstand angeklebt werden, beispielsweise eine Wärmesenke.

In Weiterbildung der Erfindung kann vorgesehen sein, die Leiterplatte mindestens in ihrem Ankopplungsbereich mit einem Träger zu verkleben. Dieser Träger kann dann die entstehende Wärme aufnehmen.

Bei dem Träger kann es sich beispielsweise um eine Platte handeln. Die Platte kann auch dazu dienen, die gesamte Leiterplatte aufzunehmen, also nicht nur in ihrem Ankopplungsbereich.

In Weiterbildung der Erfindung kann vorgesehen sein, dass der Träger, an dem die Leiterplatte mindestens in ihrem Ankopplungsbereich angeklebt ist, ein Teil eines Gehäuses des Gerätes oder einer Baugruppe ist.

Erfindungsgemäß kann vorgesehen sein, dass der Ankopplungsbereich eine geschlossene Fläche aufweist.

Es ist aber ebenfalls möglich, dass die MicroVias im Ankopplungsbereich offen und mindestens teilweise mit thermisch leitfähigem Kleber gefüllt sind.

Wenn die MicroVias zu der Seite hin offen sind, auf der die Klebefolie abgebracht wird, kann beim Laminieren der Kleber in die MicroVias eindringen.

Wenn die MicroVias auf der dem Träger abgewandten Seite der Leiterplatte als Sacklöcher angeordnet sind, können sie beim Verlöten mit Lötmittel gefüllt werden, was dann ebenfalls eine thermisch leitende Bindung bis kurz vor die gegenüberliegende Seite der Leiterplatte darstellt.

Die Erfindung schlägt vor, die Verklebung derart durchzufüh ren, dass während der Verklebung und auch anschließend keine Verformung der Leiterplatte auftritt. Eine solche Verformung könnte beispielsweise eine Aufwölbung sein.

Eine Möglichkeit, wie dies erreicht werden kann, besteht darin, dass die Klebefolie kalt laminiert wird. Unter kalt ist in diesem Zusammenhang eine Temperatur von weniger als 80°C zu verstehen.

Als Klebefolie wird beispielsweise mit Vorteil eine Acrylatfolie verwendet, die nicht aushärtet. Es wird auf diese Weise erreicht, dass die bei Temperaturänderungen auftretenden unterschiedlichen Ausdehnungen von Träger und Leiterplatte von der Klebefolie aufgenommen werden, so dass es nicht zu dem Bimetalleffekt kommt.

Erfindungsgemäß kann in Weiterbildung vorgesehen sein, dass die Hafteigenschaften der Verklebung durch einen thermischen Vorgang verbessert werden. Auch hier wird darauf geachtet, dass dadurch keine Verformung der Leiterplatte auftritt. Bei dem thermischen Prozess, der nach dem Lamininieren stattfinden kann, kann es sich beispielsweise um den Lötvorgang handeln, mit dem die Bauteile an der Leiterplatte angelötet werden. Dieser nachträgliche thermische Vorgang führt überraschenderweise dazu, dass sich die Festigkeit der Verklebung verbessert.

In Weiterbildung der Erfindung kann die Leiterplatte mindestens eine gegebenenfalls durchgehende Ausnehmung aufweisen, in der ein Bauelement angeordnet ist, das direkt an einer Wärmesenke angebracht wird. Insbesondere kann es sich dabei um eine Wärmesenke des Trägers oder den Träger selbst handeln. Gegebenenfalls kann auch die Klebefolie an dieser Stelle eine Ausnehmung aufweisen, um das Bauteil an dem Träger direkt anzubringen.

Die Erfindung schlägt vor, dass die Leiterplatte und/oder ein Bauteil mit einer Heatpipe oder einem sonstigen wärmeleitenden Element verbunden ist.

Erfindungsgemäß kann in Weiterbildung der Erfindung vorgesehen sein, die durch den Ankopplungsbereich mögliche Ankopplung nicht nur zur Abfuhr von Wärme auszunutzen, sondern auch zu einer Temperaturregelung. So könnte es beispielsweise sinnvoll sein, beim Einschalten eines Geräts eine Wärmezufuhr durchzuführen, um ein bestimmtes Bauteil auf eine Betriebstemperatur zu verringern.

Für diese Art der Temperaturregelung oder Temperatursteuerung kann erfindungsgemäß ein Träger verwendet werden, der mit Hohlräumen versehen ist, durch die ein Medium strömt. Beispielsweise kann der Träger als Platte ausgebildet sein, die zwischen zwei metallischen oder in sonstiger Weise thermisch leitenden Decklagen einen Kern mit Hohlräumen aufweist. Die Hohlräume können nach Art eines Mäanders aufgebaut sein, so dass eine Strömung durch alle Teile der Platte hindurchgeführt werden kann.

In nochmaliger Weiterbildung der Erfindung kann vorgesehen sein, den Träger derart auszubilden, dass er in eine Öffnung der Leiterplatte eingreift und ggf. durch die Öffnung hindurchgreift. Dann kann an dieser Stelle ein Bauteil direkt an dem Träger angebracht werden. Beim Durchgreifen des Trägers durch die Öffnung kann beispielsweise die Fläche der Ausformung des Trägers bündig mit der gegenüberliegenden Fläche der Leiterplatte verlaufen.

Weitere Merkmale, Einzelheiten und Vorzüge der Erfindung ergeben sich aus der folgenden Beschreibung einer bevorzugten Ausführungsform der Erfindung sowie anhand der Zeichnung. Hierbei zeigen:
- Fig. 1: einen schematischen Schnitt durch einen Bereich einer an einem Träger verklebten Leiterplatte;
- Fig. 2: eine vereinfachte Aufsicht auf einen Ankopplungsbereich der Leiterplatte der Figur 1;
- Fig. 3: eine der Figur 1 entsprechende Schnittdarstellung bei einer zweiten Ausführungsform;
- Fig. 4: einen der Figur 3 entsprechenden Schnitt bei einer dritten Ausführungsform;
- Fig. 5: einen Schnitt durch eine nochmals weitere Ausführungsform.

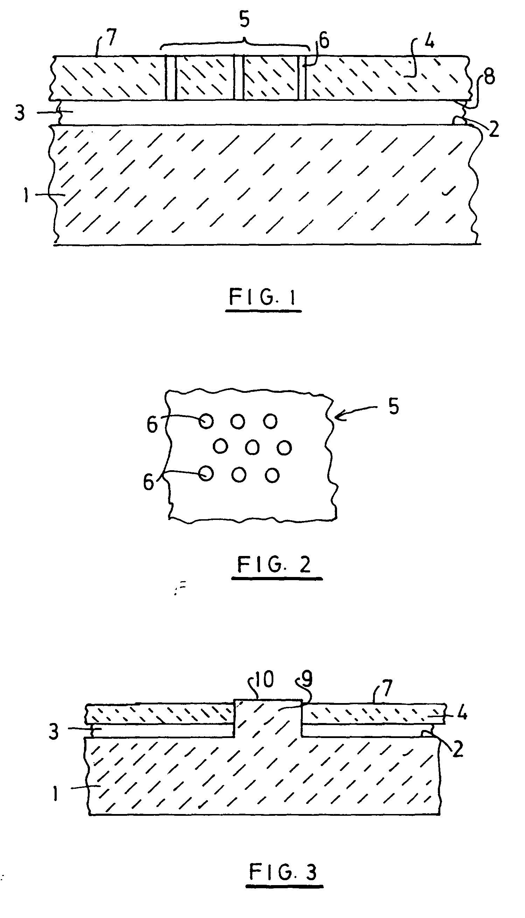

Der vereinfachte Schnitt der Figur 1 zeigt einen Träger 1, der im dargestellten Ausführungsbeispiel die Form einer ebenen Platte aufweist. An der in Figur 1 oberen Seite 2 des Trägers ist mit Hilfe einer Klebefolie 3 eine Leiterplatte 4 festgeklebt. Die Leiterplatte 4 weist einen Ankopplungsbereich 5 auf, in dem eine Vielzahl von durchgehenden MicroVias 6 ausgebildet ist. Die MicroVias 6 gehen von der freien Oberseite 7 der Leiterplatte 4 bis zu der gegenüberliegenden dem Träger 1 zugewandten Unterseite 8 durch.

Bei der Klebefolie 3 handelt es sich um eine Klebefolie, die thermisch leitend ist. Sie ist in kaltem Zustand mit dem Träger 1 und der Leiterplatte 4 laminiert. Das Laminieren kann so geschehen, dass die Klebefolie 3 mindestens teilweise in die MicroVias 6 eindringt und so eine thermisch leitende Verbindung zu den MicroVias 6 herstellt. Bei den MicroVias 6 kann es sich um kontaktierte, das heißt mit Metall ausgekleidete MicroVias handeln.

Figur 2 zeigt eine Aufsicht auf den Ankopplungsbereich 5. Dieser enthält eine Vielzahl der erwähnten MicroVias, die einen Array bilden. Die Darstellung der Figur 2 ist nur schematisch zu verstehen.

Bei der in Figur 3 dargestellten Ausführungsform enthält der Träger 1 einen über seine Fläche 2 vorspringenden Ansatz 9, der in eine entsprechende Öffnung der Leiterplatte 4 eingreift. Die Leiterplatte 4 ist in ihrem übrigen Bereich wieder mit einer Klebefolie 3 mit der Oberfläche 2 des Trägers 1 verklebt. Der Ansatz 9 weist eine solche Höhe gegenüber der Oberfläche 2 des Trägers 1 auf, dass seine Stirnfläche 10 etwa bündig mit der freien Oberseite 7 der Leiterplatte 4 verläuft. Die Fläche 10 kann eine Wärmesenke bilden, an der ein entsprechendes Bauteil angebracht wird. Beispielsweise kann hier ein direktes Ankontaktieren eines SMD-Bauelements erfolgen. Das Ausformen des Vorsprungs 9 kann beispielsweise durch ein Tiefziehen erfolgen.

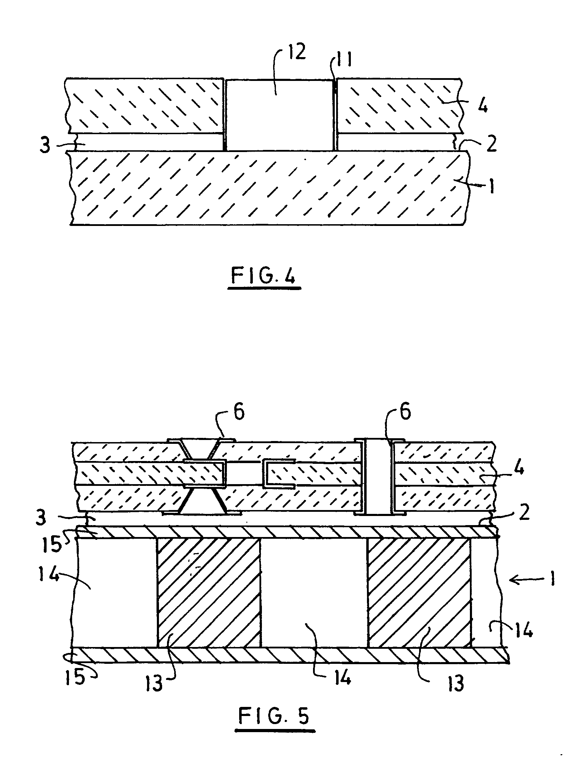

Bei der Ausführungsform der Figur 4 enthält die Leiterplatte 4 und die Klebefolie 3 eine Ausnehmung 11, in die ein Bauteil 12 eingesetzt ist. Das Bauteil 12 kann dann direkt mit dem Träger 1 verbunden werden.

Es ist ebenfalls möglich, die Ausnehmung 11 nur in der Leiterplatte 4 anzuordnen und das Bauteil 12 dann mit Hilfe der Klebefolie 3 mit dem Träger 1 zu verkleben.

Figur 5 zeigt eine nochmals weitere Ausführungsform, bei der der Träger 1 einen speziellen Aufbau aufweist. Der Träger 1 enthält einen Kern 13 beispielsweise aus Fr mit darin angeordneten Durchgängen 14. Diese Durchgänge 14 können beispielsweise parallel zueinander verlaufen oder aber auch einen fortlaufenden Durchgang bilden. Der Kern 13 ist zwischen zwei dünnen Platten 15 beispielweise aus Metall eingesetzt und mit diesen verbunden. Im Bereich der in dem Schnitt nicht zu sehenden Ränder ist dann ein Einlass und ein Auslass in die Durchgänge 14 vorgesehen. Bei dieser Ausführungsform kann ein wärmeaufnehmendes Medium, beispielsweise eine Flüssigkeit, in die Durchgänge 14 geleitet werden. Dieses Medium kann sowohl zum Kühlen als auch zum Erwärmen verwendet werden.

In Figur 5 ist die Leiterplatte 4 in größerer Einzelheit dargestellt. Sie besteht aus drei Lagen, die miteinander laminiert sind. Der Schnitt zeigt MicroVias sowohl als Sacklöcher, versetzte Durchgangslöcher und Durchgangslöcher. Wenn auf der Leiterplatte ein Bauteil angelötet wird, so kann beispielsweise der rechte MicroVia mit Lötmittel gefüllt werden, das dann eine wärmeleitende Verbindung zwischen den beiden Flachseiten der Leiterplatte 4 herstellt.

## Patentansprüche

1. Leiterplattenmontage, mit
1.1 mindestens einem Ankopplungsbereich (5), in dem
1.2 eine durchgehende elektrische und/oder thermische Verbindung von einer Seite (7) der Leiterplatte (4) zu ihrer anderen Seite (8) vorhanden ist, die
1.3 als Array von MicroVias (6) ausgebildet ist,
wobei
1.4 der Ankopplungsbereich (5) direkt mit einer thermisch leitenden nicht aushärtenden Klebefolie (3) kontaktiert ist, die
1.5 kalt laminiert ist, und
1.5 die Leiterplatte (4) mindestens in ihrem Ankopplungsbereich (5) mit einem Träger (1) verklebt ist.

2. Leiterplattenmontage nach Anspruch 1, bei der der Träger (1) eine Platte ist.

3. Leiterplattenmontage nach Anspruch 1 oder 2, bei der der Träger (1) ein Gehäuseteil eines Gerätes oder einer Baugruppe ist;

4. Leiterplattenmontage nach einem der vorhergehenden Ansprüche, bei der der Ankopplungsbereich (5) auf seiner dem Träger zugewandten Seite eine geschlossene Fläche aufweist.

5. Leiterplattenmontage nach einein der vorhergehenden Ansprüche, bei der die MicroVias (6) auf der dem Träger zugewandten Seite der Leiteplatten offen und mindestens teilweise mit thermisch leitfähigem Kleber gefüllt sind.

6. Leiterplattenmontage nach einem der vorhergehenden Ansprüche, bei der die Hafteigenschaften der Verklebung durch einen thermischen Prozess verbessert sind.

7. Leiterplattenmontage nach einem der vorhergehenden Ansprüche, bei der die Verklebung und/oder thermische Behandlung derart erfolgt, dass keine Verformung der Leiterplatte (4) auftritt.

8. Leiterplattenmontage nach einem der vorhergehenden Ansprüche, mit mindestens einer Ausnehmung in der Leiterplatte (4) und gegebenenfalls der Klebefolie (3) zur direkten Anbringung eines Bauelements an einer Wärmesenke, insbesondere einer Wärmesenke des Trägers (1).

9. Leiterplattenmontage nach einem der vorhergehenden Ansprüche, bei der die Leiterplatte (4) und/oder ein Bauteil mit einer Heatpipe oder einem sonstigen wärmeleitenden Element verbunden ist.

10. Leiterplattenmontage nach einem der vorhergehenden Ansprüche, bei der die durch den Ankopplungsbereich (5) bewirkte Ankopplung zur Temperaturregelung ausgenutzt wird.

11. Leiterplattenmontage nach einem der vorhergehenden Ansprüche, bei der der Träger (1) derart ausgebildet ist, dass er in eine Öffnung der Leiterplatte (4) eingreift und ggf. durch die Öffnung hindurchgreift.

12. Verfahren zum Anbringen einer Leiterplatte, bei dem
12.1 in mindestens einem Bereich (5) der Leiterplatte (4) ein Array von MicroVias (6) ausgebildet,
12.2 die Leiterplatte (4) mindestens in diesem Ankopplungsbereich (5) mit einer thermisch leitenden nicht aushärtenden Klebefolie (3) durch Kaltlamination verbunden und
12.3 mit einem anderen Bauteil, nämlich einem Träger, verklebt wird.

13. Verfahren nach Anspruch 12, bei dem die Microvias (6) durchgehend ausgebildet und mit Kleber gefüllt werden.

14. Verfahren nach Anspruch 12 oder 13, bei dem die Klebefolie (3) derart laminiert wird, dass eine Verformung der Leiterplatte (4) vermieden wird.

15. Verfahren nach einem der Ansprüche 12 bis 14, bei dem die Hafteigenschaften der Verklebung durch eine thermische Behandlung verbessert werden.

16. Verfahren nach einem der Ansprüche 12 bis 15, bei dem die Leiterplatte (4) mit einer ggf. durchgehenden Ausnehmung zum Anbringen eines Bauelements versehen wird.

17. Verfahren nach einem der Ansprüche 12 bis 16, bei dem die Leiterplatte (4) und/oder ein Bauteil mit einer Heatpipe oder einem sonstigen wärmeleitenden Element verbunden wird.

18. Verfahren nach einem der Ansprüche 12 bis 17, bei dem die Ankopplung durch den Ankopplungsbereich (5) zur Temperaturregelung ausgenutzt wird.

19. Verfahren nach einem der Ansprüche 12 bis 18, bei dem der Träger (1) derart ausgebildet wird, dass er in eine Öffnung der Leiterplatte (4) eingreift und ggf. durch die Öffnung hindurchgreift.

## Claims

1. Circuit board assembly, with
1.1 at least a coupling area (5), in which
1.2 a continuous electrical and/or thermal connection from one side (7) of the circuit board (4) to its other side (8) is provided, which
1.3 is designed as an array of MicroVias (5),
whereby
1.4 the coupling area (5) is directly contacted with a thermally conductive non-hardening adhesive film (3), which
1.5 is laminated in a cold state, and
1.6 a circuit board (4) is at least glued in the coupling area (5) with a substrate (1).

2. Circuit board assembly according to Claim 1, whereby the substrate (1) is a plate.

3. Circuit board assembly according to Claim 1 or 2, whereby the substrate (1) is a housing part of a device or an assembly.

4. Circuit board assembly according to one of the preceding claims, whereby the coupling area (5) exhibits an enclosed area on its side towards the substrate.

5. Circuit board assembly according to one of the preceding claims, whereby the MicroVias (6) are open towards the circuit board substrate and are at least partly filled with thermally conductive adhesive.

6. Circuit board assembly according to one of the preceding claims, whereby the adhesive properties are improved through a thermal process.

7. Circuit board assembly according to one of the preceding claims, whereby the adhesive and/or thermal treatment is done such that no deformation of the circuit board (4) occurs.

8. Circuit board assembly according to one of the preceding claims, with at least a recess in the circuit board (4) and if necessary the adhesive film (3) for direct attachment of a component to a heat sink, especially a heat sink of the substrate (1).

9. Circuit board assembly according to one of the preceding claims, whereby the circuit board (4) and/or a component is connected with a heat pipe or a sort of heat-conducting element.

10. Circuit board assembly according to one of the preceding claims, whereby the coupling established through the coupling area (5) is utilized for temperature control.

11. Circuit board assembly according to one of the preceding claims whereby the substrate (1) is designed such that it adjoins in an opening in the circuit board (4) and if necessary through the opening.

12. Process for mounting a circuit board, whereby
12.1 in at least one area (5) of the circuit board (4), an array of MicroVias (6) is formed,
12.2 the circuit board (4) at least in this coupling area (5) is connected with a thermally conductive, non-hardening adhesive film (3) through cold lamination and
12.3 glued with another component, namely a substrate.

13. Process according to Claim 12, whereby the Microvias (6) are continuously formed and filled with adhesive.

14. Process according to Claim 12 or 13, whereby the adhesive film (3) is laminated such that deformation of the circuit board (4) is prevented.

15. Process according to one of the Claims 12 to 14, whereby the adhering properties of the adhesive are improved through a thermal treatment.

16. Process according to one of the Claims 12 to 15, whereby the circuit board (4) is provided with a continuous recess for attaching a component.

17. Process according to one of the Claims 12 to 16, whereby the circuit board (4) and/or a component is connected with a heat pipe or a sort of heat-conducting element.

18. Process according to one of the Claims 12 to 17, whereby the coupling through the coupling area (5) is utilized for temperature control.

19. Process according to one of the Claims 12 to 18, whereby the substrate (1) is designed such that it adjoins in an opening in the circuit board (4) and if necessary through the opening.

## Revendications

1. Montage de plaquettes à circuits imprimés, comprenant
1.1 au moins une zone de couplage (5), dans laquelle
1.2 une liaison électrique et/ou thermique continue est présente d'un côté (7) de la plaquette à circuits imprimés (4) à son autre côté (8), qui
1.3 est constituée en rangée de micro vias (6),
1.4 la zone de couplage (5) étant directement en contact avec une feuille adhésive (3) thermo-conductrice et non durcissable, qui
1.5 est laminée à froid, et
1.6 la plaquette à circuits imprimés (4) étant collée à un support (1) au moins dans sa zone de couplage (5).

2. Montage de plaquettes à circuits imprimés selon la revendication 1, dans lequel le support (1) est une plaque.

3. Montage de plaquettes à circuits imprimés selon la revendication 1 ou 2, dans lequel le support (1) est une partie de boîtier d'un appareil ou d'un sous-groupe.

4. Montage de plaquettes à circuits imprimés selon l'une quelconque des revendications précédentes, dans lequel la zone de couplage (5) présente une surface fermée sur son côté tourné vers le support.

5. Montage de plaquettes à circuits imprimés selon l'une quelconque des revendications précédentes, dans lequel les micro vias (6) sont ouverts sur le côté des plaquettes à circuits imprimés tourné vers le support et sont remplis, tout du moins en partie, de colle thermo-conductrice.

6. Montage de plaquettes à circuits imprimés selon l'une quelconque des revendications précédentes, dans lequel les propriétés adhésives du collage sont améliorées au moyen d'un processus thermique.

7. Montage de plaquettes à circuits imprimés selon l'une quelconque des revendications précédentes, dans lequel le collage et/ou le traitement thermique est effectué/sont effectués de telle manière qu'il ne se produit pas de déformation de la plaquette à circuits imprimés (4).

8. Montage de plaquettes à circuits imprimés selon l'une quelconque des revendications précédentes, comprenant au moins un évidement dans la plaquette à circuits imprimés (4) et, le cas échéant, dans la feuille adhésive (3) pour l'application directe d'un composant sur un dissipateur thermique, en particulier un dissipateur thermique du support (1).

9. Montage de plaquettes à circuits imprimés selon l'une quelconque des revendications précédentes, dans lequel la plaquette à circuits imprimés (4) et/ou un composant est raccordé/sont raccordés à un tube de chauffe ou à un autre élément thermo-conducteur.

10. Montage de plaquettes à circuits imprimés selon l'une quelconque des revendications précédentes, dans lequel le couplage obtenu au moyen de la zone de couplage (5) est utilisé pour le réglage de température.

11. Montage de plaquettes à circuits imprimés selon l'une quelconque des revendications précédentes, dans lequel le support (1) est constitué de telle manière qu'il a prise dans un orifice de la plaquette à circuits imprimés (4) et, le cas échéant, traverse cet orifice.

12. Procédé de pose d'une plaquette à circuits imprimés, dans lequel
12.1 une rangée de micro vias (6) est constituée dans au moins une zone (5) de la plaquette à circuits imprimés (4),
12.2 la plaquette à circuits imprimés (4) est raccordée par laminage à froid, au moins dans cette zone de coupage (5), à une feuille adhésive (3) thermo-conductrice et non durcissable, et
12.3 est collée à un autre composant, à savoir un support.

13. Procédé selon la revendication 12, dans lequel les micro vias (6) sont formés de manière traversante et sont remplis de colle.

14. Procédé selon la revendication 12 ou 13, dans lequel la feuille adhésive (3) est laminée de telle manière qu'une déformation de la plaquette à circuits imprimés (4) est évitée.

15. Procédé selon l'une des revendications 12 à 14, dans lequel les propriétés adhésives du collage sont améliorées au moyen d'un traitement thermique.

16. Procédé selon l'une des revendications 12 à 15, dans lequel la plaquette à circuits imprimés (4) est munie d'un évidement éventuellement traversant pour la pose d'un composant.

17. Procédé selon l'une des revendications 12 à 16, dans lequel la plaquette à circuits imprimés (4) et/ou un composant est raccordé/sont raccordés à un tube de chauffe ou à un autre élément thermo-conducteur.

18. Procédé selon l'une des revendications 12 à 17, dans lequel le couplage au moyen de la zone de couplage (5) est utilisé pour le réglage de température.

19. Procédé selon l'une des revendications 12 à 18, dans lequel le support (1) est formé de telle manière qu'il a prise dans un orifice de la plaquette à circuits imprimés (4) et, le cas échéant, traverse cet orifice.
